# EUROPÄISCHE PATENTANMELDUNG

(11) **EP 4 742 080 A1**
(43) Veröffentlichungstag der Anmeldung: **13.05.2026**
(21) Anmeldenummer: 25214604.8
(22) Anmeldetag: 10.11.2025
(51) Int. Cl.: G06F 30/33, G01R 31/3183, G06F 30/27

(54) **VERFAHREN ZUM ERSTELLEN EINES PSEUDOMODELLS EINER ELEKTRISCHEN SCHALTUNG**

(30) Priorität: 11.11.2024 DE 102024132812
(71) Anmelder: GÖPEL electronic GmbH, 07745 Jena (DE)
(72) Erfinder: Münch, Norbert, 07629 Hermsdorf (DE); Wenzel, Ricardo, 07749 Jena (DE); Leidenfrost, Sven, 07570 Weida (DE); Labrada Diaz, Alexander, 07743 Jena (DE)
(74) Vertreter: Gleim Petri Patent- und Rechtsanwaltspartnerschaft mbB

(57) **Zusammenfassung**

Die Erfindung betrifft ein Verfahren zum Erstellen eines Pseudomodells 1 einer elektrischen Schaltung für die Abschätzung einer Testabdeckung auf Basis eines Konstruktionsmodells 2 der elektrischen Schaltung. Es werden dabei nacheinander ein erster, zweiter und dritter Datensatz 4, 6, 8 mittels eines ersten, zweiten und dritten trainierten neuronalen Netzwerkes 3, 5, 7 erstellt, indem die neuronalen Netzwerke 3, 5, 7 jeweils aus dem Konstruktionsmodell 2 und den aus vorherigen Verfahrensschritten bekannten Datensätzen 4, 6, 8 erste, zweite und dritte Modelldaten extrahieren und kategorisieren. Schlussendlich erfolgt ein Zusammenführen der Datensätze 4, 6, 8 sowie dem Konstruktionsmodell 2 zu einem Pseudomodell 1, welches die elektrische Schaltung annähert. Die ersten, zweiten und dritten Modelldaten umfassen jeweils eine andere der folgenden Informationen: eine Bauteilkategorie eines jeden Bauteils der elektrischen Schaltung, eine Pinkategorie eines jeden Pins jedes Bauteils der elektrischen Schaltung und eine Netzkategorie eines jeden aus mehreren miteinander elektrisch verbundenen Pins gebildeten Netzes.

## Beschreibung

Die Erfindung betrifft ein Verfahren zum Erstellen eines Pseudomodells einer elektrischen Schaltung für die Abschätzung einer Testabdeckung auf Basis eines Konstruktionsmodells der elektrischen Schaltung.

Die Testung komplexer elektrischer Schaltungen ist ein entscheidender Schritt im Entwicklungsprozess elektronischer Geräte. Mit dem stetigen Fortschritt in der Halbleitertechnologie und der wachsenden Funktionalität von Schaltkreisen, sei es in Mikroprozessoren, Kommunikationsmodulen oder Steuergeräten, steigen auch die Anforderungen an die Verlässlichkeit und Präzision dieser Systeme. Es gilt dabei nicht nur einzelne Komponenten zu prüfen, sondern die Analyse umfasst auch die Prüfung des gesamten Systems auf Funktionsfähigkeit unter verschiedenen Betriebszuständen.

Eine zentrale Herausforderung bei der Testung besteht darin, die richtige Balance zwischen Testtiefe und Testaufwand zu finden. Aufgrund der Komplexität moderner Schaltungen ist es oft unmöglich, jede mögliche Kombination von Eingangssignalen und Betriebszuständen vollständig nachzubilden. Daher bedarf es effizienter Teststrategien, die eine möglichst umfassende Überprüfung relevanter Fehlerquellen gewährleisten, ohne den Testprozess unnötig zu verlängern oder zu verteuern.

Ein wesentlicher Aspekt derartiger Testverfahren ist die Bestimmung der Testabdeckung, die beschreibt, welche Zahl der möglichen Fehler oder Zustände während des Tests im Verhältnis zur Gesamtheit überprüft werden. Eine hohe Testabdeckung bedeutet dabei, dass die Wahrscheinlichkeit unentdeckter Fehler im System gering ist.

Ein Verfahren zur Abschätzung der Testabdeckung ist in der US 2004 / 0 044 973 A1 offenbart. Dabei werden potenzielle Defekte numerisch erfasst, ohne zu berücksichtigen wie nach diesen getestet wird. Die Defekte werden nach einem Punktesystem bewertet, welches anzeigt, ob der jeweilige Defekt in einer Testung festgestellt werden würde. Im Anschluss wird aus den vergebenen Punkten eine Testabdeckung bestimmt. Die möglichen Defekte werden abgeschätzt, indem Bauteile und Verbindungen der zugrundeliegenden elektrischen Schaltung kategorisiert und bewertet werden.

Bei sehr komplexen Schaltungen ist eine derartige Bestimmung der Testabdeckung regelmäßig mit erheblichem Aufwand verbunden. Üblicherweise erfordert die Datengenerierung zur Testabdeckungsanalyse umfangreiche manuelle Eingaben. Ein Ansatz besteht darin, ein Konstruktionsmodell der elektrischen Schaltung, welches zum Beispiel als CAD-Datei vorliegen kann und alle relevanten Informationen zur elektronischen Leiterplatte beinhaltet, als Basis zu verwenden. Um die Testabdeckung bestimmen zu können, müssen sämtliche Komponenten des Konstruktionsmodells klassifiziert und modelliert werden. Anschließend werden diese Daten an einen Testgenerator übergeben, welcher auf Basis der Schaltungsarchitektur sowie vordefinierter Testkriterien geeignete Testmuster bestimmt, um eine möglichst breite Palette an Fehlerszenarien abzudecken. Dazu benötigt ein Testgenerator Informationen wie die Baustein-Klasse, Pin-Eigenschaften oder eine Funktionsbeschreibung. Diese werden bisher vom Nutzer eingetragen oder zugewiesen, da ohne eine entsprechende Beschreibung der Komponente keine Testabdeckung ermittelt werden kann. Es entsteht ein für den Testgenerator verwertbares Pseudomodell der elektrischen Schaltung, anhand dessen die Testabdeckung bestimmt werden kann. Dieser manuelle Ansatz ist jedoch sehr aufwendig.

Es ist die Aufgabe der Erfindung, den Aufwand für das Bestimmen der Testabdeckung mittels eines Testgenerators zu reduzieren und die Genauigkeit zu erhöhen.

Diese Aufgabe wird durch ein Verfahren zum Erstellen eines Pseudomodells einer elektrischen Schaltung für die Abschätzung einer Testabdeckung auf Basis eines Konstruktionsmodells der elektrischen Schaltung gelöst, welches die folgenden Schritte umfasst:
- Erstellen eines ersten Datensatzes aus dem Konstruktionsmodell durch ein erstes trainiertes neuronales Netzwerk, welches erste Modelldaten extrahiert und diese kategorisiert,
- Erstellen eines zweiten Datensatzes aus dem Konstruktionsmodell und dem ersten Datensatz durch ein zweites trainiertes neuronales Netzwerk, welches zweite Modelldaten extrahiert und diese kategorisiert und
- Erstellen eines dritten Datensatzes aus dem Konstruktionsmodell, dem ersten Datensatz und dem zweiten Datensatz durch ein drittes trainiertes neuronales Netzwerk, welches dritte Modelldaten extrahiert und kategorisiert, und
- Zusammenführen der ersten, zweiten und dritten Datensätze sowie dem Konstruktionsmodell zu einem Pseudomodell, welches die elektrische Schaltung annähert, wobei die ersten, zweiten und dritten Modelldaten jeweils eine andere der folgenden Informationen umfassen:
   i. eine Bauteilkategorie eines jeden Bauteils der elektrischen Schaltung,
   ii. eine Pinkategorie eines jeden Pins jedes Bauteils der elektrischen Schaltung und
   iii. eine Netzkategorie eines jeden aus mehreren miteinander elektrisch verbundenen Pins gebildeten Netzes.

Das Ergebnis des Verfahrens ist kein vollständiges Modell der elektrischen Schaltung, sondern ein der elektrischen Schaltung angenähertes Pseudomodell, welches vor allem diejenigen Daten enthält, die ein Testgenerator benötigt, um die Testabdeckung bestimmen zu können. Es muss sich bei dem Pseudomodell nicht einmal um das Modell irgendeiner Schaltung handeln, solange der Testgenerator aus den Daten des Pseudomodells eine Testabdeckung für die zugrundeliegende elektrische Schaltung bestimmen kann.

Die Testabdeckung gibt als zentraler Parameter zur Beschreibung einer Schaltung bzw. für die Schaltungsentwicklung an, in welchem Umfang die Schaltung im Rahmen automatisierter Testverfahren auf ihre Funktionalität überprüft werden kann. Eine hohe Testabdeckung ist insbesondere im Hinblick auf die Produktionssicherheit und die Fehlerdiagnose wünschenswert. Eine bei der Schaltungsentwicklung angestrebte Testabdeckung beeinflusst unmittelbar die Architektur der Schaltung - beispielsweise durch die gezielte Integration von testfreundlichen Strukturen oder spezieller Prüfmodi. Ihre Bestimmung, ob vollständig oder in Annäherung, und in Erweiterung somit auch das Bestimmen des Pseudomodells, welches zur direkten Abschätzung der Testabdeckung dient, steht als solche somit in direktem Zusammenhang mit der technischen Aufgabe, die Prüf- und Diagnosefähigkeit komplexer Schaltungen zu verbessern. Andererseits ist die Bestimmung der Testabdeckung regelmäßig ein wesentlicher Bestandteil der Konzeption und Entwicklung von Testsystemen und zu einer konkreten Schaltung passenden Testszenarien, da durch ihre systematische Analyse gezielt Testlücken identifiziert werden können.

Es ist zur Bestimmung der Testabdeckung jedoch nicht zwingend notwendig, jeden möglichen Test vollständig zu planen, sondern hinreichend, die generelle Anwendbarkeit eines bestimmten Tests und dessen Abdeckung im Gesamtsystem zu bestimmen. Die so bestimmte Testabdeckung weicht höchstens im geringen Umfang von der tatsächlichen für die elektrische Schaltung ab. Durch entsprechendes Training der neuronalen Netzwerke kann eine sehr hohe Genauigkeit erreicht werden. Die neuronalen Netzwerke werden dabei idealerweise durch eine Vielzahl an manuell erstellten Modellen trainiert.

Im Allgemeinen ist frei wählbar, welche Modelldaten zum Erstellen des ersten, zweiten und dritten Datensatzes verwendet werden. Bei der Ausführung des Verfahrens hat es sich aber als zweckmäßig erwiesen, zunächst die Netzkategorie, anschließend die Bauteilkategorie und abschließend die Pinkategorie zu bestimmen. Somit umfassen in einer vorteilhaften Ausgestaltung des Verfahrens die ersten Modelldaten die Netzkategorie, die zweiten Modelldaten die Bauteilkategorie und die dritten Modelldaten die Pinkategorie. Die Eigenschaften der Netze lassen sich am leichtesten aus dem Konstruktionsmodell bestimmen und können gut als Eingabe für die Bauteilkategorie verwendet werden. Das Kategorisieren der Pins hat am besten Erfolg, wenn die Bauteilkategorie und die Netze bereits bekannt sind.

Das Konstruktionsmodell der elektrischen Schaltung enthält typischerweise Daten zu den verwendeten Bauteilen, zum Beispiel ihre Zahl, Anordnung, elektrische Verbindungen sowie Identifikatoren und Herstellertypbezeichnungen, Informationen zu Gehäuseformen insbesondere von integrierten Schaltungen (ICs) sowie Signalnamen und deren Zuweisung, also wo ein Signal anliegt. Aus der genauen Anzahl der Bauteile, ihrer Pins sowie deren elektrische Verbindungen können folgende Kennzahlen bestimmt werden:
a. Gesamtzahl der Netze
b. Gesamtzahl der Bauteile
c. Gesamtzahl der Pins
d. Anzahl Bauteile in einem Netz
e. Anzahl der Pins in einem Netz
f. Anzahl der Pins an einem Bauteil
g. Anzahl der anliegenden Signale an einem Bauteil.

Die Modelldaten, die zentral für das Pseudomodell extrahiert und kategorisiert werden, umfassen wie oben beschrieben die Bauteilkategorie, die Pinkategorie und die Netzkategorie, zu welchen im Folgenden näher ausgeführt werden soll.

Als Netz ist hier eine Gruppe an Pins zu verstehen, die allesamt miteinander elektrisch in Verbindung stehen, so dass an ihnen stets dasselbe Signal anliegt. Mindestens eines der Netze ist zum Beispiel die Erdung der Schaltung, so dass jeder Pin, der direkt elektrisch mit dem Erdpotential in Verbindung steht, Teil des Netzes "Erde" ist. Ähnliches gilt für Pins, an denen eine Versorgungsspannung anliegt. Diese bilden ein gemeinsames Netz mit einem Ausgang ihrer jeweiligen Spannungsquelle sowie den jeweils anderen, ebenfalls mit dem Ausgang der Spannungsquelle verbundenen Pins. Auf ähnliche Weise können solche Netze kategorisiert werden, die zur Signalübertragung dienen. Es hat sich dabei für die Nutzung des Systems im Bereich der Prüfung von RAM, Flashspeicher und Interkonnektivitätsmessungen als günstig herausgestellt, wenn den Netzen jeweils einer der folgenden, ihre Zugehörigkeit charakterisierenden, mindestens vorhandenen Werte als die Netzkategorie zugeordnet wird: Spannungsversorgung, Erde, JTAG-TMS, JTAG-TCK, JTAG-TDIO. JTAG steht dabei für "joint test action group", TMS für "test mode select", TCK für "test clock" und TDIO für "test data input/output". Zweckmäßig ist es außerdem, alle nicht direkt einer Netzkategorie zuzuordnenden Netze unter einer sonstigen Kategorie, zum Beispiel "Signal" abzulegen. Je nach Anwendungsbereich kann die Liste der Kategorien ergänzt werden, oder es können Unterkategorien eingeführt oder anderweitige Anpassungen vorgenommen werden. Das zuständige neuronale Netzwerk verarbeitet mindestens die Bezeichner der Netze aus dem Konstruktionsmodell sowie die an den Netzen liegende Pin- und Bauteilanzahl.

Die Bauteilkategorie umfasst den konkreten Typ eines Bauteils, also ob es sich um einen Widerstand, einen Kondensator, einen RAM-Baustein, einen Operationsverstärker oder dergleichen handelt. Dies ist nicht immer unmittelbar aus den Daten des Konstruktionsmodells zu entnehmen. Dazu verwendet das entsprechende neuronale Netzwerk zum Beispiel Daten wie Pin-Anzahl, die aus dem Konstruktionsmodell bekannt ist, um das jeweilige Bauteil der elektrischen Schaltung zu klassifizieren. Zum Beispiel besitzt ein Widerstand oder Kondensator zwei Pins, ein Transistor drei, eine integrierte Schaltung oder ein RAM-Baustein hingegen eine Vielzahl. Der Bezeichner des Bauteils im Konstruktionsmodell unterliegt häufig einem festgelegten Muster. Widerstände tragen oft den Präfix R, Steckverbinder XH, Kondensatoren C und so weiter. Diese Präfixe können entsprechend durch das jeweilige neuronale Netzwerk ausgewertet werden. Im Ergebnis werden Bauteilkategorien wie zum Beispiel Widerstand, Kondensator, Induktor, Transistor, Diode, Relais, Jumper, Schalter, Testpunkt, Sicherung, Steckverbindung, Drahtverbindung, RAM, Flashspeicher oder IC kategorisiert. Das neuronale Netz, welches die Bauteile kategorisiert, nutzt als Eingangsdaten mindestens den Bezeichner, den Typ, die Anzahl der Pins sowie den Namen der angeschlossenen Netze.

In einer vorteilhaften Ausgestaltung zur Prüfung von RAM, Flashspeicher und der Messung der Interkonnektivität wird den Bauteilen jeweils einer der folgenden, ihre Zugehörigkeit charakterisierenden, mindestens vorhandenen Werte als die Bauteilkategorie zugeordnet: Widerstand, Kondensator, Induktor, Transistor, Diode, Relais, Steckverbinder, Schalter, Testpunkt, Flashspeicher, RAM und Boundary Scan IC, welcher eine durch Grenzpfadabtastung (Boundary Scan) zu testende integrierte Schaltung ist. Besonders vorteilhaft werden die restlichen Bauteile, welche vor allem verschiedene Arten an integrierten Schaltungen; die nicht durch einen Boundary Scan getestet werden, in eine sonstige Kategorie "IC" eingeordnet.

Die Pinkategorie wird im Wesentlichen entsprechend der Funktion eines jeden Pin vergeben. Das zuständige trainierte neuronale Netzwerk verwendet dabei zum Herleiten der Pinkategorie mindestens die vorhandenen Daten der zu den Bauteilen und den Netzen aus dem Konstruktionsmodell. Im Bereich der Prüfung von RAM, Flashspeicher und den zugehörigen Interkonnektivitätsmessungen ist es vorteilhaft, wenn den Pins jeweils einer der folgenden, ihre Zugehörigkeit charakterisierenden, mindestens vorhandenen Werte als die Pinkategorie zugeordnetwird: Spannungsversorgung, Erde, RAM-Adresse, RAM-Daten, RAM-Steuersignal, FLASH-Adresse, FLASH-Daten, FLASH-Steuersignal, JTAG-TMS, JTAG-TCK, JTAG-TDIO. Wie bei der Kategorisierung der Netze und Bauteile ist es auch hier günstig, Pins, die nicht den genannten Kategorien zuzuordnen sind, einer Kategorie "Sonstige" zuzuordnen.

Sind zu wenige Daten im Konstruktionsmodell vorhanden oder hat ein neuronales Netzwerk eine inkorrekte Zuordnung getroffen, so ist es von Vorteil, wenn beim Erstellen des ersten Datensatzes, beim Erstellen des zweiten Datensatzes oder beim Erstellen des dritten Datensatzes eine Nutzereingabe priorisiert von den trainierten neuronalen Netzwerken berücksichtigt wird, um dies zu korrigieren und die Qualität der durch die neuronalen Netzwerke getroffenen Zuordnungen zu verbessern. Besonders vorteilhaft erfolgt nach dem Erstellen des ersten, des zweiten und des dritten Datensatzes jeweils eine Prüfung auf eine manuelle Nutzereingabe.

Ferner ist es günstig, wenn vor dem Zusammenführen zu einem Pseudomodell das erste, das zweite oder das dritte neuronale Netzwerk auf Basis aller vorhandenen Datensätze das Erstellen des jeweiligen Datensatzes wiederholen. Da so dem ersten trainierten neuronalen Netzwerk neben dem Konstruktionsmodell auch die zweiten und dritten Datensätze für die Auswertung zur Verfügung stehen, werden eine deutlich höhere Genauigkeit erzielt, da die logische Zuordnung der ersten Modelldaten erleichtert wird, und die Qualität für das Pseudomodell verbessert. Auch können eventuell ungenaue oder inkorrekte Zuordnungen von dem ersten trainierten neuronalen Netzwerk erkannt und korrigiert werden, wenn sie sich im Kontext des zweiten und dritten Datensatzes ergeben. Das gleiche gilt analog für das zweite und das dritte trainierte neuronale Netzwerk. Das zweite neuronale Netzwerk greift dann neben dem gegebenenfalls schon einmal durch Wiederholung verbesserten ersten Datensatz auf den dritten Datensatz zu, so dass der zweite Datensatz erneut und verbessert erstellt wird. Entsprechendes gilt für den dritten Datensatz, für den das dritte neuronale Netzwerk insbesondere mit bereits verbesserten ersten und zweiten Datensätzen ein noch genaueres Ergebnis produzieren kann.

Um bereits das Erstellen der Datensätze durch die trainierten neuronalen Netzwerke zu verbessern, verarbeiten die trainierten neuronalen Netzwerke mindestens folgende Informationen: Bauteil-Bezeichner, Bauteil-Typ, Bauteilpaket-Bezeichner, Signalname, Signalzuweisung, Anzahl an Pins, Anzahl an Netzen, Anzahl an Bauteilen, Bauteil-Pinanzahl, Informationen zur Ausgestaltung der Netze, also welche Pins jeweils miteinander verbunden sind. Es ist dabei möglich, aber nicht zwingend notwendig, dass jedes der trainierten neuronalen Netzwerke alle dieser Daten verarbeitet, dies ist jedoch besonders vorteilhaft. Für eine verbesserte Bestimmung des ersten, zweiten oder dritten Datensatzes ist es im Allgemeinen hinreichend, wenn jede der genannten Informationen aus dem Konstruktionsmodell von mindestens einem trainierten neuronalen Netzwerk berücksichtigt wird.

Die Aufgabe der Erfindung wird ferner durch ein Verfahren zur Bestimmung einer Testabdeckung für eine elektrische Schaltung gelöst, wobei zunächst ein Pseudomodell erzeugt wird, wie es gerade beschrieben wurde, das Pseudomodell an einen Testgenerator übergeben wird, welcher zur Erstellung eines Testmusters für eine elektrische Schaltung geeignet ist, der Testgenerator ein Testmuster für das Pseudomodell erstellt und die Testabdeckung der elektrischen Schaltung anhand des Testmusters für das Pseudomodell abgeschätzt wird. Der Testgenerator kann dabei selbst als ein weiteres trainiertes neuronales Netzwerk oder als Software ausgebildet sein, der die in dem Pseudomodell vorhandenen Informationen zu Netzen, Bauteilen und Pins mit dem Konstruktionsmodell der elektrischen Schaltung kombiniert und spezifische Tests simuliert. Der Anteil erfolgreich getesteter Komponenten an ihrer Gesamtzahl entspricht dann der Testabdeckung. So können außerdem verschiedene Testgeneratoren, die verschiedene Testmuster erstellen, da sie zum Beispiel andere Schwerpunkte setzen, leicht miteinander verglichen und das Testmuster mit der höchsten Testabdeckung ausgewählt werden. Auch eine tiefergehende Analyse von einzelnen Bauteilgruppen der elektrischen Schaltung ist auf diese Weise möglich.

Ferner wird die Aufgabe durch ein Computerprogramm gelöst, welches auf einem Rechner ausführbar ist und bewirkt, dass der Rechner ein Verfahren zur Bestimmung der Testabdeckung oder zum Erstellen eines Pseudomodells ausführt.

Es versteht sich, dass die vorstehend genannten und die nachstehend noch zu erläuternden Merkmale nicht nur in den angegebenen Kombinationen, sondern auch in anderen Kombinationen oder in Alleinstellung einsetzbar sind, ohne den Rahmen der vorliegenden Erfindung zu verlassen.

Nachfolgend wird die Erfindung anhand eines Ausführungsbeispiels noch näher erläutert. Dieses Ausführungsbeispiel dient lediglich der Veranschaulichung und ist nicht als einschränkend auszulegen. Beispielsweise ist eine Beschreibung des Ausführungsbeispiels mit einer Vielzahl von Elementen oder Komponenten nicht dahingehend auszulegen, dass alle diese Elemente oder Komponenten zur Implementierung notwendig sind. Vielmehr können andere Ausführungsbeispiele auch alternative Elemente und Komponenten, weniger Elemente oder Komponenten oder zusätzliche Elemente oder Komponenten enthalten. Modifikationen und Abwandlungen, welche beschrieben werden, können auch auf andere Ausführungsbeispiele anwendbar sein. Es zeigt:

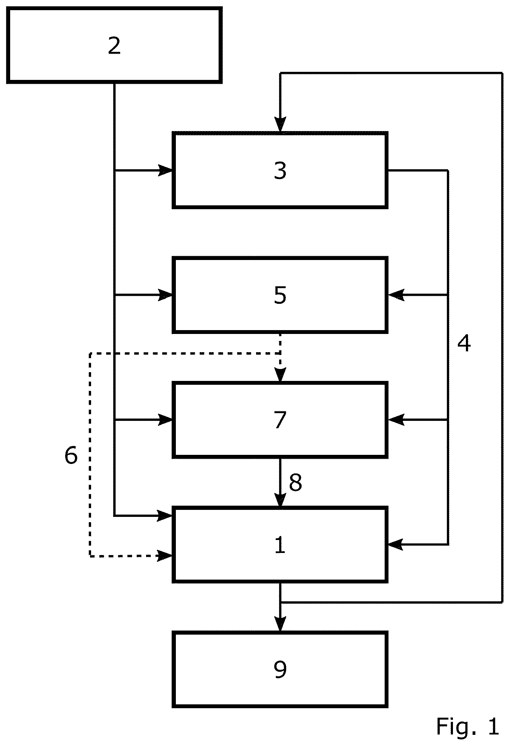

- Fig. 1: ein Flussdiagramm des Verfahrens zum Bestimmen einer Testabdeckung.

Fig. 1 zeigt ein Flussdiagramm des oben beschriebenen Verfahrens zum Erstellen eines Pseudomodells 1 einer elektrischen Schaltung für die Abschätzung einer Testabdeckung auf Basis eines Konstruktionsmodells 2 der elektrischen Schaltung, dessen Ablauf im Folgenden beschrieben wird. Das Konstruktionsmodell 2 wird zunächst in ein erstes trainiertes neuronales Netzwerk 3 geladen, welches erste Modelldaten, zum Beispiel eine Netzkategorie eines jeden aus mehreren miteinander elektrisch verbundenen Pins gebildeten Netzes, extrahiert und diese kategorisiert, um einen ersten Datensatz 4 zu erhalten. Dazu werden Informationen aus dem Konstruktionsmodell 2, wie Bauteil-Bezeichner, Bauteil-Typ, Bauteilpaket-Bezeichner, Signalname, Signalzuweisung, Anzahl an Pins, Anzahl an Netzen, Anzahl an Bauteilen, Bauteil-Pinanzahl und Informationen zur konkreten Ausgestaltung der Netze, entnommen und von dem ersten trainierten neuronalen Netzwerk 3 verarbeitet. Der erste Datensatz 4 wird an ein zweites trainiertes neuronales Netzwerk 5 übergeben, welches außerdem die oben genannten Daten aus dem Konstruktionsmodell 2 als Eingangsdaten erhält. Diese Informationen werden von dem zweiten trainierten neuronalen Netzwerk 5 verwendet, um zweite Modelldaten, wie zum Beispiel eine Bauteilkategorie eines jeden Bauteils der elektrischen Schaltung, zu extrahieren und zu kategorisieren, um einem zweiten Datensatz 6 zu erhalten und auszugeben. Die gestrichelte Darstellung des ausgegebenen zweiten Datensatzes 6 dient hier lediglich dem besseren Verständnis der Zeichnung und hat darüberhinausgehend keine besondere Bedeutung. Anschließend werden die Informationen aus dem Konstruktionsmodell 2, der erste Datensatz 4 und der zweite Datensatz 6 an ein drittes trainiertes neuronales Netzwerk 7 übergegeben. Dieses erstellt einen dritten Datensatz 8, indem es dritte Modelldaten, zum Beispiel eine Pinkategorie eines jeden Pins jedes Bauteils der elektrischen Schaltung, extrahiert und kategorisiert. Das Konstruktionsmodell 2, der erste Datensatz 4 der zugeordneten Netzkategorien, der zweite Datensatz 6 der zugeordneten Bauteilkategorien und der dritte Datensatz 8 der zugeordneten Pinkategorien werden weiterverarbeitet und zu einem Pseudomodell 1 der elektrischen Schaltung zusammengesetzt. Sind die extrahierten Informationen nicht ausreichend, wird das Pseudomodell 1 bzw. werden die Datensätze 4, 6, 8 und die Daten des Konstruktionsmodells 2 in Gänze erneut dem ersten, zweiten oder dem dritten trainierten neuronalen Netzwerk 3, 5, 7 zugeführt, so dass die Bestimmung der Datensätze 4, 6, 8 wiederholt wird. Im Ausführungsbeispiel werden die Daten exemplarisch an das erste trainierte neuronale Netzwerk 3 übergeben und der gesamte Ablauf von dort wiederholt.

Fehlerhafte Zuordnungen sowie Netze, Bauteile und Pins, die nicht zugeordnet wird konnten, können vor jedem Verfahrensschritt durch die nicht dargestellte Eingabe eines Nutzers angepasst werden. Die trainierten neuronalen Netzwerke 3, 5, 7 behandeln derartige Eingaben priorisiert zu eigenen Kategorisierungen und berücksichtigen diese bei der Kategorisierung der Netze, Bauteile oder Pins.

Ist das Pseudomodell 1 fertig erstellt, wird es an einen Testgenerator 9 übergeben. Dieser entwickelt ein Testmuster für das Pseudomodell 1 der zugrundeliegenden elektrischen Schaltung des Konstruktionsmodells 2, aus dem sich eine Testabdeckung ergibt.

Der Testgenerator 9 ist dabei entweder selbst als ein weiteres trainiertes neuronales Netzwerk ausgebildet, oder eine auf die verschiedenen Test- bzw. Modelltypen der elektrischen Schaltung abgestimmte, gegebenenfalls kombinierte Softwarelösung. Er verarbeitet die in den Datensätzen 4, 6, 8 vorhandenen Informationen zu den Netzen, den Bauteilen und den Pins zusammen mit dem Konstruktionsmodell 2 der elektrischen Schaltung, um spezifische Tests zu simulieren. Im vorliegenden Ausführungsbeispiel markiert der Testgenerator 9 die in den Bauteilen verwendeten Pins mit Testattributen. Solche Testattribute sind beispielsweise die Signalrichtung (IN, OUT, INOUT) oder der Signalpegel (LOW, HIGH, BOTH) des Pins sowie die grundlegenden Test- oder Pin-Funktionen (wie beispielsweise RAM-Adresse oder Flash-Daten). Auf Basis der Testattribute erfolgt schließlich eine Bewertung, ob und wie die jeweiligen Pins im Rahmen des vom Testgenerator 9 erzeugten Testmusters getestet werden würden. Um die Testabdeckung schlussendlich zu bestimmen werden sämtliche erfolgreich mit hinreichenden Testattributen versehene Pins in das Verhältnis zur Gesamtzahl aller Pins gesetzt. Je nach Einstellung des verwendeten Testgenerators 9 oder durch Verwendung mehrerer unterschiedlicher Testgeneratoren 9 können so die Testabdeckungen verschiedener Testmuster für die elektrische Schaltung ausgewertet und verglichen werden.

### Bezugszeichenliste

- 1: Pseudomodell
- 2: Konstruktionsmodell
- 3: erstes trainiertes neuronales Netzwerk
- 4: erster Datensatz
- 5: zweites trainiertes neuronales Netzwerk
- 6: zweiter Datensatz
- 7: drittes trainiertes neuronales Netzwerk
- 8: dritter Datensatz
- 9: Testgenerator

## Patentansprüche

1. Verfahren zum Erstellen eines Pseudomodells (1) einer elektrischen Schaltung für die Abschätzung einer Testabdeckung auf Basis eines Konstruktionsmodells (2) der elektrischen Schaltung, umfassend die folgenden Schritte:
- Erstellen eines ersten Datensatzes (4) aus dem Konstruktionsmodell (2) durch ein erstes trainiertes neuronales Netzwerk (3), welches erste Modelldaten extrahiert und diese kategorisiert,
- Erstellen eines zweiten Datensatzes (6) aus dem Konstruktionsmodell (2) und dem ersten Datensatz (4) durch ein zweites trainiertes neuronales Netzwerk (5), welches zweite Modelldaten extrahiert und diese kategorisiert und
- Erstellen eines dritten Datensatzes (8) aus dem Konstruktionsmodell (2), dem ersten Datensatz (4) und dem zweiten Datensatz (6) durch ein drittes trainiertes neuronales Netzwerk (7), welches dritte Modelldaten extrahiert und kategorisiert, und
- Zusammenführen der ersten, zweiten und dritten Datensätze (4, 6, 8) sowie dem Konstruktionsmodell (2) zu einem Pseudomodell (1), welches die elektrische Schaltung annähert, wobei die ersten, zweiten und dritten Modelldaten jeweils eine andere der folgenden Informationen umfassen:
i. eine Bauteilkategorie eines jeden Bauteils der elektrischen Schaltung,
ii. eine Pinkategorie eines jeden Pins jedes Bauteils der elektrischen Schaltung und
iii. eine Netzkategorie eines jeden aus mehreren miteinander elektrisch verbundenen Pins gebildeten Netzes.

2. Verfahren nach Anspruch 1, wobei
- die ersten Modelldaten die Netzkategorie,
- die zweiten Modelldaten die Bauteilkategorie und
- die dritten Modelldaten die Pinkategorie umfassen.

3. Verfahren nach Anspruch 1 oder 2, wobei den Netzen jeweils einer der folgenden, ihre Zugehörigkeit charakterisierenden, mindestens vorhandenen Werte als die Netzkategorie zugeordnet wird: Spannungsversorgung, Erde, JTAG-TMS, JTAG-TCK, JTAG-TDIO.

4. Verfahren nach einem der Ansprüche 1 bis 3, wobei den Bauteilen jeweils einer der folgenden, ihre Zugehörigkeit charakterisierenden, mindestens vorhandenen Werte als die Bauteilkategorie zugeordnet wird: Widerstand, Kondensator, Induktor, Transistor, Diode, Relais, Steckverbinder, Schalter, Testpunkt, RAM, Flashspeicher, Boundary Scan IC.

5. Verfahren nach einem der Ansprüche 1 bis 4, wobei den Pins jeweils einer der folgenden, ihre Zugehörigkeit charakterisierenden, mindestens vorhandenen Werte als die Pinkategorie zugeordnet wird: Spannungsversorgung, Erde, RAM-Adresse, RAM-Daten, RAM-Steuersignal, FLASH-Adresse, FLASH-Daten, FLASH-Steuersignal, JTAG-TMS, JTAG-TCK, JTAG-TDIO.

6. Verfahren, nach einem der Ansprüche 1 bis 5, wobei beim Erstellen des ersten Datensatzes (4), beim Erstellen des zweiten Datensatzes (6) oder beim Erstellen des dritten Datensatzes (8) eine Nutzereingabe priorisiert von den trainierten neuronalen Netzwerken (3, 5, 7) berücksichtigt wird.

7. Verfahren nach einem der Ansprüche 1 bis 6, wobei vor dem Zusammenführen zu einem Pseudomodell (1) das erste, das zweite oder das dritte neuronale Netzwerk (3, 5, 7) auf Basis aller vorhandenen Datensätze (4, 6, 8) das Erstellen des jeweiligen Datensatzes (4, 6, 8) wiederholen.

8. Verfahren nach einem der Ansprüche 1 bis 7, wobei aus dem Konstruktionsmodell (2) mindestens folgende Informationen durch die trainierten neuronalen Netzwerke (3, 5, 7) verarbeitet werden: Bauteil-Bezeichner, Bauteil-Typ, Bauteilpaket-Bezeichner, Signalname, Signalzuweisung, Anzahl an Pins, Anzahl an Netzen, Anzahl an Bauteilen, Bauteil-Pinanzahl, Informationen zur Ausgestaltung der Netze.

9. Verfahren zur Bestimmung einer Testabdeckung für eine elektrische Schaltung, wobei
- zunächst ein Pseudomodell (1) nach einem der Ansprüche 1 bis 8 erzeugt wird,
- das Pseudomodell (1) an einen Testgenerator (9) übergeben wird, welcher zur Erstellung eines Testmusters für eine elektrische Schaltung geeignet ist,
- der Testgenerator (9) ein Testmuster für das Pseudomodell erstellt und
- die Testabdeckung der elektrischen Schaltung anhand des Testmusters (9) für das Pseudomodell (1) abgeschätzt wird.

10. Computerprogramm, welches auf einem Rechner ausführbar ist und bewirkt, dass der Rechner ein Verfahren nach den vorangehenden Ansprüchen ausführt.
